# EUROPEAN PATENT APPLICATION

(11) **EP 2 226 567 A1**
(43) Date of publication of application: **08.09.2010**
(21) Application number: 08863858.0
(22) Date of filing: 22.10.2008
(51) Int. Cl.: F24C 15/10, C03C 17/09, C03C 17/22, C03C 17/36, H05B 6/12

(54) **TOP PLATE FOR COOKING APPLIANCE AND PROCESS FOR PRODUCING THE SAME**

(30) Priority: 20.12.2007 JP 2007328911
(71) Applicant: Nippon Electric Glass Co., Ltd., Otsu-shi Shiga 520-8639 (JP)
(72) Inventor: IKEGAMI, Koji, Otsu-shi Shiga 520-8639 (JP)
(74) Representative: Tetzner, Michael
(86) International application number: PCT/JP2008/069112
(87) International publication number: WO 2009/081649

(57) **Abstract**

To provide a top plate for a cooking appliance which can be given various colors and has good heat resistance. A top plate for a cooking appliance disposed over the cooking appliance includes: a glass substrate; an interference layer disposed on one side of the glass substrate and made of silicon nitride or aluminium nitride; a light shielding layer disposed on the interference layer and made of titanium or niobium; and a protective layer disposed on the light shielding layer and made of at least one material selected from the group consisting of silicon nitride, zirconium nitride, titanium nitride, tantalum nitride, tungsten nitride, and niobium nitride, wherein the interference layer and the protective layer are thin films each formed by physical vapor deposition in a gas atmosphere having a N₂ gas content of 90% to 100% by volume.

## Description

### TECHNICAL FIELD

This invention relates to top plates for cooking appliances disposed over electromagnetic (IH) cooking appliances, infrared cooking appliances, gas cooking appliances or like cooking appliances, and processes for producing the same.

### BACKGROUND ART

As top plates used for electromagnetic cooking appliances and infrared cooking appliances, low thermal expansion glass, ceramics or like material is used. Low thermal expansion glass, ceramics or like material has also come into use for top plates for gas cooking appliances because of its excellent aesthetic quality and cleanability. In these top plates using such glass or like material, a metal film, such as a Ti film, is formed on a substrate in order to visually hide internal components, such as a cooking appliance and a temperature sensor. The metal film gives a beauty of metallic luster or the like to the top plate.

However, top plates using a Ti film as a light shielding layer cannot be given various colors other than a silver color that is a characteristic color of a Ti film used as a protective layer. Therefore, there is a demand for a top plate for a cooking appliance which can be given various colors and is excellent in heat resistance.

Patent Document 1 proposes top plates for cooking appliances using various metal films, such as Si and Ti, as their light shielding layers. However, the top plates for cooking appliances proposed in this document are intended to be those that can be given various colors and have excellent heat resistance, but cannot satisfy a stricter standard of heat resistance.
Patent Document 1: Published Japanese Patent Application No. 2004-333102

### DISCLOSURE OF THE INVENTION

An object of the present invention is to provide a top plate for a cooking appliance which can be given various colors and has good heat resistance, and to provide a process for producing the same.

The present invention provides a top plate for a cooking appliance disposed over the cooking appliance, the top plate including: a glass substrate; an interference layer disposed on one side of the glass substrate and made of silicon nitride or aluminium nitride; a light shielding layer disposed on the interference layer and made of titanium or niobium; and a protective layer disposed on the light shielding layer and made of at least one material selected from the group consisting of silicon nitride, zirconium nitride, titanium nitride, tantalum nitride, tungsten nitride, and niobium nitride, wherein the interference layer and the protective layer are thin films each formed by physical vapor deposition in a gas atmosphere having a N₂ gas content of 90% to 100% by volume.

In the present invention, an interference layer, a light shielding layer and a protective layer are stacked in this sequence one on another on a glass substrate, the interference layer and the protective layer are formed of nitride thin films, and the formation of the nitride thin films for the interference layer and the protective layer by physical vapor deposition is implemented in a gas atmosphere having a N₂ gas content of 90% to 100% by volume. By using as the interference layer and the protective layer the thin films formed in a gas atmosphere having a N₂ gas content of 90% to 100% by volume in the above manner, a top plate for a cooking appliance having good heat resistance can be provided.

The details of the reason why in the present invention good heat resistance can be achieved by forming the interference layer and the protective layer in a gas atmosphere having a N₂ gas content of 90% to 100% by volume are not completely clear. However, because of the formation of the interference layer and the protective layer in a gas atmosphere having a N₂ gas content of 90% to 100% by volume, dense nitride thin films can be formed, and even if the thin films are subjected to heat application during a heat resistance test, the change in film thickness is small. It can be assumed that therefore the top plate exhibits good heat resistance. Note that in the present invention, the heat resistance means that the top plate shows only a slight change in color tone due to a heat resistance test.

In the present invention, the change in film thickness of each of the interference layer and the protective layer due to the heat resistance test is preferably 10% or less.

In the present invention, as described above, the interference layer and the protective layer are each formed in a gas atmosphere having a N₂ gas content of 90% to 100% by volume. If the N₂ gas content is too small, good heat resistance cannot be achieved. The more preferred range of N₂ gas content is 95% to 100% by volume, and the still more preferred range is 97.5% to 100% by volume.

In the present invention, the interference layer is formed of a nitride thin film made of silicon nitride or aluminium nitride. By varying the film thickness of the interference layer, the top plate for a cooking appliance can be given various colors. The thickness of the interference layer is preferably within the range of 5 to 250 nm. If the film thickness is too small, the interference effect between the glass substrate and the interference layer and the interference effect between the interference layer and the light shielding layer are less likely to be achieved, and therefore the top plate may not be given various colors. On the other hand, if the film thickness is too large, the technical effect cannot be correspondingly achieved, sometimes leading to an economic disadvantage. If the interference layer is made of silicon nitride, the film thickness is more preferably within the range of 50 to 250 nm. If the interference layer is made of aluminium nitride, the film thickness is more preferably within the range of 5 to 50 nm.

In the present invention, the light shielding layer is made of titanium or niobium. By making the light shielding layer from titanium or niobium, good heat resistance can be achieved. The thickness of the light shielding layer is preferably within the range of 75 to 150 nm. If the thickness of the light shielding layer is too small, the light shielding ability to hide the internal structure of the cooking appliance is reduced, whereby the aesthetic quality may be impaired. On the other hand, if the film thickness of the light shielding layer is too large, the technical effect cannot be correspondingly achieved, sometimes leading to an economic disadvantage.

In the present invention, the protective layer is formed of a nitride thin film made of at least one material selected from the group consisting of silicon nitride, zirconium nitride, titanium nitride, tantalum nitride, tungsten nitride, and niobium nitride. By forming the protective layer from such a nitride thin film, good heat resistance can be achieved. The thickness of the protective layer is preferably within the range of 50 to 200 nm. If the film thickness of the protective layer is too small, good heat resistance may not be achieved. On the other hand, if the film thickness of the protective layer is too large, the technical effect cannot be correspondingly achieved, sometimes leading to an economic disadvantage.

The top plate for a cooking appliance according to the present invention has good heat resistance. In the top plate for a cooking appliance according to the present invention, a change in chromaticity of the top plate due to a heat resistance test at 500°C for 30 minutes is such that a variation in each of x and y coordinates as indices of the chromaticity falls within ±0.03.

The interference layer and the protective layer in the present invention are formed by physical vapor deposition. Examples of the physical vapor deposition include thin film formation processes, such as sputtering, vacuum evaporation, and ion plating. Particularly preferred is the formation of the interference layer and the protective layer by sputtering. When a nitride thin film is conventionally formed by physical vapor deposition, such as sputtering, a mixture gas in which an inert gas, such as Ar (argon) gas, is mixed with N₂ gas is used as an atmosphere gas. However, if an interference layer and a protective layer are formed in a conventional gas atmosphere containing a large amount of inert gas, such as Ar gas, such good heat resistance as achieved according to the present invention cannot be achieved. In the present invention, a top plate for a cooking appliance having excellent heat resistance can be provided by selecting the N₂ gas content within the range of 90% to 100% by volume.

In the present invention, the process for forming a thin film for the light shielding layer is not particularly limited. However, the light shielding layer can also be formed by physical vapor deposition, like the interference layer and the protective layer. Examples of the physical vapor deposition include sputtering, vacuum evaporation, and ion plating. Among them, the process particularly preferably used is sputtering. The gas atmosphere in forming the light shielding layer is not particularly limited so long as a thin film made of titanium or niobium can be formed. For example, the light shielding layer can be formed also in an atmosphere of inert gas, such as Ar gas.

Materials that can be used as a glass substrate in the present invention include glasses resistant to rapid cooling from 600°C, i.e., glasses excellent in so-called thermal shock resistance. Specifically, the preferred glasses are those having a thermal expansion coefficient of 50 x 10⁻⁷/°C or less. For example, low-expansion borosilicate glasses, low-expansion silica glasses and low-expansion crystallized glasses containing beta-quartz solid solution as a primary crystal can be used. Particularly preferred are glasses having an average thermal expansion coefficient of -10 to +30 x 10⁻⁷/°C in the temperature range of 30°C to 500°C, and more preferred are glasses having an average thermal expansion coefficient of -10 to +20 x 10⁻⁷/°C in the above temperature range, because all of them have still higher thermal shock resistance and are less likely to cause stress and be broken even if the temperature distribution in the glass substrate becomes wide during heat application.

A production process according to the present invention is a process capable of producing the above top plate for a cooking appliance according to the present invention, and includes the steps of: forming the interference layer on the glass substrate by physical vapor deposition in a gas atmosphere having a N₂ gas content of 90% to 100% by volume; forming the light shielding layer on the interference layer; and forming the protective layer on the light shielding layer by physical vapor deposition in a gas atmosphere having a N₂ gas content of 90% to 100% by volume.

According to the production process of the present invention, a top plate for a cooking appliance can be produced which can be given various colors by varying the film thickness of the interference layer and has good heat resistance.

In the production process of the present invention, the interference layer and the protective layer can be formed by physical vapor deposition, such as sputtering, vacuum evaporation or ion plating, as described above. Furthermore, since these layers are formed in a gas atmosphere having a N₂ gas content of 90% to 100% by volume, a top plate for a cooking appliance can be provided which shows only a slight chromaticity change between before and after the heat resistance test and therefore has good heat resistance.

### (Effects of the Invention)

The top plate for a cooking appliance of the present invention can be given various colors by varying the material and film thickness of the interference layer. Furthermore, according to the present invention, since the interference layer and the protective layer are formed by physical vapor deposition in a gas atmosphere having a N₂ gas content of 90% to 100% by volume, the top plate shows only a slight chromaticity change between before and after the heat resistance test and therefore can obtain good heat resistance.

### BEST MODE FOR CARRYING OUT THE INVENTION

Hereinafter, the present invention will be described with reference to specific examples but is not limited to the following examples.

### [Production of Top Plate for Cooking Appliance]

Crystallized glass ("Neoceram N-0" having an average linear thermal expansion coefficient of 0 x 10⁻⁷/°C in the temperature range of 30°C to 500°C and a thickness of 4 mm, manufactured by Nippon Electric Glass, Co., Ltd.) was used as glass substrates. Film materials shown in TABLES 1 to 4 were used to form respective interference layers, light shielding layers and protective layers in this sequence with thicknesses shown in TABLES 1 to 4 on the glass substrates by sputtering. Note that the film formation atmospheres in forming respective layers by sputtering were gas atmospheres shown in TABLES 1 to 4. The unit "%" in the gas atmosphere conditions shown in these tables represents % by volume.

### [Heat Resistance Test]

The top plates thus obtained were subjected to a heat resistance test. The heat resistance test was implemented by heating each top plate at 500°C for 30 minutes in an electric furnace. Before and after subjected to a heat resistance test, the top plates were measured for color tone and chromaticity. Based on changes in color tone and chromaticity between before and after the heat resistance test, the top plates were evaluated for heat resistance. Note that the larger the change in chromaticity, the more the color tone changed and the lower the heat resistance.

The color tone was evaluated by visually observing the color of each top plate sample from the glass substrate side (the side on which no film was formed).

The chromaticity was obtained by allowing light at wavelengths from 400 to 700 nm to enter each top plate from the glass substrate side, measuring the reflectance of the light with a spectro-photometer and calculating the chromaticity from the reflectance according to JIS (Japanese Industrial Standard) Z 8071.

The evaluation results on heat resistance are shown in TABLES 1 to 4.

**[TABLE 1]**

| | | No. | 1 | No. | 2 | No. | 3 | No. 4 | |
|---|---|---|---|---|---|---|---|---|---|
| Glass Substrate | | Crystallized Glass | | Crystallized Glass | | Crystallized Glass | | Crystallized Glass | |
| Interference Layer | Film Material | Si₃N₄ | | Si₃N₄ | | Si₃N₄ | | Si₃N₄ | |
| | Film Thickness (nm) | 237. 5nm | | 237. 5nm | | 237. 5nm | | 237. 5nm | |
| | Film Formation Atmosphere | N₂ : 100% | | N₂: 9 7% Ar : 3% | | N₂ :95% Ar:5% | | N₂ :100% | |
| Light Shielding Layer | Film Material | Nb | | Nb | | Nb | | Nb | |
| | Film Thickness(nm) | 100nm | | 100nm | | 100nm | | 100nm | |
| | Atmosphere | Ar : 100% | | Ar : 100% | | Ar : 100% | | Ar : 100% | |
| Protective Layer | Film Material | Si₃N₄ | | Si₃N₄ | | Si₃N₄ | | Si₃N₄ | |
| | Film Thickness(nm) | 100nm | | 100nm | | 100nm | | 100nm | |
| | Film Formation Atmosphere | N₂ : 100% | | N₂ : 1 00 % | | N : 100% | | N₂ : 98% Ar:2% | |
| Color Tone | Before Heat Resistance test | Blackish Silver | | Blackish Silver | | Blackish Silver | | Blackish Silver | |
| | After Heat Resistance Test | Blackish Silver | | Blackish Silver | | Blackish Silver | | Blackish Silver | |
| Chromaticity(x,y) | Before Heat Resistance Test | 0.364 | 0.309 | 0.365 | 0.309 | 0.364 | 0.310 | 0.364 | 0.310 |
| | After Heat Resistance Test | 0.363 | 0.310 | 0.354 | 0.320 | 0.344 | 0.329 | 0.358 | 0.317 |

**[TABLE 2]**

| | | No. 5 | | No. 6 | | No. 7 | | No. 8 | |
|---|---|---|---|---|---|---|---|---|---|
| Glass Substrate | | Crystallized Glass | | Crystallized Glass | | Crystallized Glass | | Crystallized Glass | |
| Interference Layer | Film Material | Si₃N₄ | | Si₃N₄ | | Si₃N₄ | | Si₃N₄ | |
| | Film Thickness (nm) | 237. 5nm | | 194nm | | 222nm | | 238nm | |
| | Atmosphere | N₂ : 100% | | N₂ : 100% | | N₂ : 100% | | N₂ : 100% | |
| Light Shielding Layer | Film Material | Nb | | Nb | | Nb | | Nb | |
| | Film Thickness(nm) | 100nm | | 100nm | | 100nm | | 100nm | |
| | Atmosphere | | | Ar : 100% | | Ar : 100% | | Ar : 100% | |
| Protective Layer | Film Material | Si₃N₄ | | Si₃N₄ | | Si₃N₄ | | Si₃N₄ | |
| | Film Thickness (nm) | 100nm | | 100nm | | 100nm | | 100nm | |
| | Film Formation Atmosphere | N₂ : 95% | | N₂ : 100% | | N₂ : 100% | | N₂ : 100% | |
| | | Ar : 5% | | | | | | | |
| Color Tone | Before Heat Resistance test | Blackish Silver | | Purplish Silver | | Blue-Greenish Silver | | Greenish Silver | |
| | After Heat Resistance Test | Blackish Silver | | Purplish Silver | | Blue-Greenish Silver | | Greenish Silver | |
| Chromaticity(x,y) | Before Heat Resistance test | 0.365 | 0.310 | 0.312 | 0.245 | 0.365 | 0.355 | 0.341 | 0.391 |
| | After Heat Resistance Test | 0.345 | 0.329 | 0.309 | 0.243 | 0.367 | 0.354 | 0.344 | 0.391 |

**[TABLE 3]**

| | | No. 9 | | No. 10 | | No. 11 | |
|---|---|---|---|---|---|---|---|
| Glass Substrate | | Crystallized Glass | | Crystallized Glass | | Crystallized Glass | |
| Interference Layer | Film Material | Si₃N₄ | | AlN | | A1N | |
| | Film Thickness(nm) | 250nm | | 8 nm | | 8 nm | |
| | Film Formation Atmosphere | N₂ : 100% | | N₂ : 100% | | N₂ : 95% Ar : 5% | |
| Light Shielding Layer | Film Material | Nb | | Nb | | Nb | |
| | Film Thickness(nm) | 100nm | | 100nm | | 100nm | |
| | Atmosphere | Ar : 100% | | Ar : 100% | | Ar : 100% | |
| Protective Layer | Film Material | Si₃N₄ | | Si₃N₄ | | Si₃N₄ | |
| | Film Thickness(nm) | 100nm | | 100nm | | 100nm | |
| | Film Formation Atmosphere | N₂ : 100% | | N₂ : 98% | | N₂ : 100% | |
| | | | | A r : 2 % | | | |
| Color Tone | Before Heat Resistance test | Yellow-Greenish Silver | | Blackish Silver | | Blackish Silver | |
| | After Heat Resistance Test | Yellow-Greenish Silver | | Blackish Silver | | Blackish Silver | |
| Chromaticity(x,y) | Before Heat ResistanceTest | 0.329 | 0.389 | 0.329 | 0.345 | 0.330 | 0.344 |
| | After Heat Resistance Test | 0.328 | 0.387 | 0.337 | 0.351 | 0.347 | 0.360 |

**[TABLE 4]**

| | | No. 12 | | No. 13 | |
|---|---|---|---|---|---|
| Glass Substrate | | Crystallized Glass | | Crystallized Glass | |
| Interference Layer | Film Material | Si₃N₄ | | Si₃N₄ | |
| | Film Thickness(nm) | 230nm | | 230nm | |
| | Film Formation Atmosphere | N₂ : 60% | | N₂ : 100% | |
| | | Ar : 40% | | | |
| Light Shielding Layer | Film Material | Nb | | Nb | |
| | Film Thickness(nm) | 100nm | | 100nm | |
| | Film Formation Atmosphere | Ar : 100% | | Ar : 100% | |
| Protective Layer | Film Material | Si₃N₄ | | Si₃N₄ | |
| | Film Thickness (nm) | 100nm | | 100nm | |
| | Film Formation | N₂ : 100% | | N₂ : 60% | |
| | Atmosphere | | | Ar : 40% | |
| Color Tone | Before Heat ResistanceTest | Bluish Silver | | Bluish Silver | |
| | After Heat Resistance Test | Purplish Silver | | Purplish Silver | |
| Chromaticity(x,y) | Before Heat ResistanceTest | 0.316 | 0.237 | 0.316 | 0.237 |
| | After Heat Resistance Test | 0.288 | 0.203 | 0.288 | 0.203 |

Samples Nos. 1 to 11 are examples according to the present invention, and Samples Nos. 12 and 13 are comparative examples.

For Sample No. 12, the gas atmosphere conditions in forming an interference layer were 60% N₂ gas and 40% Ar gas. Sample No. 12 of a comparative example having an interference layer formed under the above gas atmosphere conditions significantly changed the color tone and chromaticity between before and after the heat resistance test and therefore could not obtain good heat resistance.

For Sample No. 13, the gas atmosphere conditions in forming a protective layer were 60% N₂ gas and 40% Ar gas. Sample No. 13 of a comparative example formed in the above gas atmosphere significantly changed the color tone and chromaticity between before and after the heat resistance test and therefore could not obtain good heat resistance.

In contrast, Samples Nos. 1 to 11 including interference layers and protective layers each formed in a gas atmosphere having a N₂ gas content of 90% to 100% by volume showed only slight changes in color tone and chromaticity between before and after the heat resistance test and therefore obtained good heat resistance.

For Samples Nos. 1 to 11, top plates for cooking appliances having various color tones were obtained by using Si₃N₄ or AlN as an interference layer and varying the film thickness of the interference layer.

Although in the above inventive examples a Nb (niobium) film was used as a light shielding layer, it has been confirmed that even if a Ti (titanium) film is used instead as a light shielding layer, the same effects can be obtained.

Although in the above inventive examples a Si₃N₄ film was used as a protective layer, it has been confirmed that if zirconium nitride, titanium nitride, tantalum nitride, tungsten nitride or niobium nitride is used instead as a protective layer, the same effects can be obtained.

## Claims

1. A top plate for a cooking appliance disposed over the cooking appliance, the top plate comprising:
a glass substrate;
an interference layer disposed on one side of the glass substrate and made of silicon nitride or aluminium nitride;
a light shielding layer disposed on the interference layer and made of titanium or niobium; and
a protective layer disposed on the light shielding layer and made of at least one material selected from the group consisting of silicon nitride, zirconium nitride, titanium nitride, tantalum nitride, tungsten nitride, and niobium nitride,
wherein the interference layer and the protective layer are thin films each formed by physical vapor deposition in a gas atmosphere having a N₂ gas content of 90% to 100% by volume.

2. The top plate for a cooking appliance of claim 1, wherein the thickness of the interference layer is within the range of 5 to 250 nm.

3. The top plate for a cooking appliance of claim 1 or 2, wherein the thickness of the light shielding layer is within the range of 75 to 150 nm.

4. The top plate for a cooking appliance of any one of claims 1 to 3, wherein the thickness of the protective layer is within the range of 50 to 200 nm.

5. The top plate for a cooking appliance of any one of claims 1 to 4, wherein a change in chromaticity of the top plate due to a heat resistance test at 500°C for 30 minutes is such that a variation in each of x and y coordinates falls within ±0.03.

6. A process for producing the top plate for a cooking appliance of any one of claims 1 to 5, the process comprising the steps of:
forming the interference layer on the glass substrate by physical vapor deposition in a gas atmosphere having a N₂ gas content of 90% to 100% by volume;
forming the light shielding layer on the interference layer; and
forming the protective layer on the light shielding layer by physical vapor deposition in a gas atmosphere having a N₂ gas content of 90% to 100% by volume.
